# FASCICULE DE BREVET EUROPEEN

(11) **EP 3 168 990 B1**
(45) Date de publication et mention de la délivrance du brevet: **02.09.2020**
(21) Numéro de dépôt: 16194575.3
(22) Date de dépôt: 19.10.2016
(51) Int. Cl.: H03H 7/06, H03H 7/40, H04B 3/54, H04B 3/56

(54) **RÉGLAGE DE LA RÉINJECTION D'UN SIGNAL D'ÉMISSION DANS UNE CHAîNE DE RÉCEPTION D'UN ÉQUIPEMENT DE TRANSMISSION DE DONNÉES PAR COURANTS PORTEURS EN LIGNE**
UNTERDRÜCKUNG DES ÜBERSPRECHENS EINES SENDESIGNALS IN DEN EMPFÄNGERPFAD EINER VORRICHTUNG FÜR DIE DATENÜBERTRAGUNG IN EINEM POWERLINE SYSTEM
ADJUSTMENT OF THE REINJECTION OF A TRANSMITTED SIGNAL INTO THE RECEIVING CHANNEL OF A SYSTEM FOR TRANSMITTING DATA BY POWERLINE COMMUNICATION

(30) Priorité: 20.10.2015 FR 1559976
(43) Date de publication de la demande: 17.05.2017
(73) Titulaire: General Electric Technology GmbH, 5400 Baden (CH)
(72) Inventeur: Guilhem, Laurent, 94300 Vincennes (FR); Fontenelle, François, 91190 Gif-sur-Yvette (FR)
(74) Mandataire: Brevalex

(56) Documents cités:
- WO-A1-2014/056575
- US-A1- 2006 038 662
- US-B1- 7 142 094

## Description

### DOMAINE TECHNIQUE

La présente invention concerne de manière générale le domaine des courants porteurs en ligne (CPL) qui permettent de constituer un réseau de transmission de données sur un réseau électrique.

Elle concerne plus précisément le réglage de la réinjection d'un signal d'émission côté courants porteurs dans une chaîne de réception d'un équipement de transmission de données par courants porteurs en ligne.

### ÉTAT DE LA TECHNIQUE ANTÉRIEURE

Dans la suite, on s'intéresse plus spécifiquement aux équipements de dernière génération utilisant une modulation digitale.

Différents types de modulations sont utilisables. Certaines modulations, comme L'OFDM (Orthogonal Frequency Division Multiplexing) utilisent deux bandes de fréquences distinctes, respectivement pour un sens de transmission des données et pour l'autre sens.

D'autres modulations, comme la modulation QAM (Quadrature Amplitude Modulation), peuvent utiliser une même bande de fréquence pour les deux sens de transmission des données. C'est ce que l'on appelle le mode de transmission superposé. Pour un fonctionnement optimal des transmissions de données à une extrémité, ce mode exige un effacement efficace, en réception, des données émises vers un récepteur distant.

Une des caractéristiques principale des systèmes de transmission par courants porteurs est que l'on ne maitrise pas l'impédance du support (voir WO2014/056575).

Cela pose notamment un problème lorsque la ligne utilisée est une ligne à haute tension d'un réseau de transport d'électricité. L'impédance présentée par la ligne et les organes de couplage peut être très différente de l'impédance nominale de l'accès de l'équipement. De plus, l'impédance de la ligne varie au cours du temps, en particulier en fonction des conditions météorologiques.

Cette désadaptation de l'impédance de la ligne par rapport à l'impédance de l'accès de l'équipement peut provoquer une réinjection importante du signal de l'émetteur local sur le récepteur. Cette réinjection parasite perturbe la bonne réception du signal à recevoir. Comme la puissance du signal émis est généralement plus forte que celle du signal reçu, cette réinjection peut masquer complétement le signal reçu et empêcher la synchronisation de la liaison.

La plupart des équipements sont munis d'un dispositif de transformation 2 fils / 4 fils utilisant généralement un transformateur différentiel asymétrique, dit transformateur hybride. Une compensation d'impédance complexe (résistive et capacitive en général) dans l'un des enroulements du transformateur permet de minimiser la réinjection de l'émetteur local sur le récepteur. Le réglage de la compensation est réalisé manuellement et une fois pour toutes à la mise en service des équipements. Dans ces conditions, les variations de l'impédance de la ligne au cours du temps ne sont pas prises en compte, et la réinjection du signal émis peut perturber la réception des données, en particulier si les conditions d'environnement de la ligne d'énergie changent.

### EXPOSÉ DE L'INVENTION

L'invention vise à résoudre les problèmes de la technique antérieure en fournissant un dispositif de réglage selon la revendication 1.

Grâce à l'invention, la réinjection du signal émis sur le canal de réception d'un équipement CPL de transmission de données est limitée.

En outre, le réglage périodique de la réinjection du signal émis sur le canal de réception permet de s'adapter aux variations d'impédance de la ligne qui peuvent survenir au cours du temps.

Selon une caractéristique préférée, le dispositif de réglage est adapté à régler la valeur prédéterminée de puissance et comporte :
- un moyen d'émission d'un signal de référence,
- un moyen de mesure de la puissance d'un signal réinjecté dans la chaîne de réception lorsque le signal de référence est émis, et
- un moyen de réglage de la valeur de l'impédance de compensation, adapté à minimiser la puissance du signal réinjecté, la valeur prédéterminée de puissance étant réglée à la valeur minimale de la puissance du signal réinjecté.

Ainsi le dispositif de réglage est initialisé.

Selon une caractéristique préférée, le signal de référence est un signal de porteuse émission utilisé dans une modulation du signal d'émission.

Le signal de référence est ainsi obtenu très facilement.

Selon une caractéristique préférée alternative, le signal de référence est un signal sinusoïdal prédéterminé. Cette caractéristique est utile lorsque la modulation ne comporte pas de signal de porteuse émission.

Selon une caractéristique préférée, le dispositif de réglage est un dispositif de réglage selon la revendication 5.

L'invention concerne aussi un équipement de transmission de données par courants porteurs en ligne, caractérisé en ce qu'il comporte un dispositif de réglage tel que précédemment présenté.

L'invention concerne aussi un procédé de réglage selon la revendication 7.

Selon une caractéristique préférée, le procédé de réglage est adapté à régler la valeur prédéterminée de puissance et comporte des étapes de :
- émission d'un signal de référence,
- mesure de la puissance d'un signal réinjecté dans la chaîne de réception lorsque le signal de référence est émis, et
- réglage de la valeur de l'impédance de compensation, de manière à minimiser la puissance du signal réinjecté, la valeur prédéterminée de puissance étant réglée à la valeur minimale de la puissance du signal réinjecté.

L'équipement et le procédé présentent des avantages analogues à ceux précédemment présentés.

Dans un mode particulier de réalisation, les étapes du procédé selon l'invention sont mises en œuvre par des instructions de programme d'ordinateur.

En conséquence, l'invention vise aussi un programme d'ordinateur sur un support d'informations, ce programme étant susceptible d'être mis en œuvre dans un ordinateur, ce programme comportant des instructions adaptées à la mise en œuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en œuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

### BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :
La figure 1 représente un équipement de transmission de données par courants porteurs en ligne, selon un mode de réalisation de la présente invention,
La figure 2 représente un exemple schématique de répartition fréquentielle de signaux émis et reçus par un équipement de transmission de données par courants porteurs en ligne,
La figure 3 représente un module d'impédance de compensation variable, selon un mode de réalisation de la présente invention, et
La figure 4 représente un procédé de de réglage de la réinjection d'un signal d'émission dans une chaîne de réception d'un équipement de transmission de données par courants porteurs en ligne, selon un mode de réalisation de la présente invention.

### EXPOSÉ DÉTAILLÉ DE MODES DE RÉALISATION PARTICULIERS

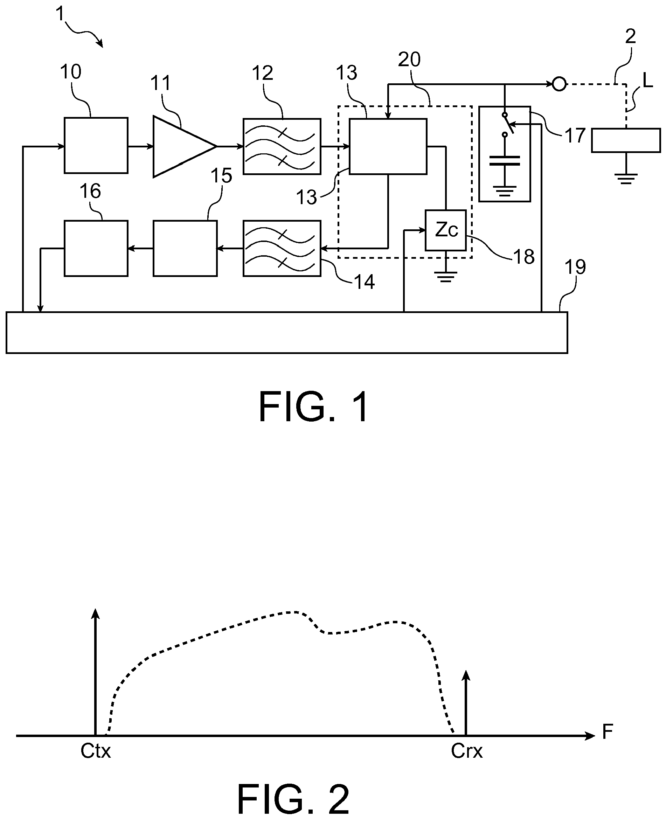

Selon un mode de réalisation préféré, représenté à la **figure 1**, un équipement 1 de transmission de données par courants porteurs en ligne est destiné à être connecté à une ligne haute tension L.

Seuls les éléments utiles à la compréhension de l'invention sont décrits dans la suite.

L'équipement 1 comporte pour la partie émission de données un convertisseur numérique/analogique 10 pour recevoir des données à émettre. Le convertisseur 10 forme un signal analogique à partir des données qu'il reçoit.

La sortie du convertisseur numérique/analogique 10 est reliée à l'entrée d'un amplificateur de puissance 11. Le convertisseur 10 transmet le signal analogique qu'il a formé à l'amplificateur de puissance 11 dont le but est d'amplifier le signal qu'il reçoit.

La sortie de l'amplificateur de puissance 11 est reliée à l'entrée d'un filtre d'émission 12 qui réalise un filtrage passe-bande du signal qu'il reçoit. Le signal filtré est ainsi dans la bande de fréquence d'émission de l'équipement.

La sortie du filtre d'émission 12 est reliée à l'entrée d'un convertisseur deux fils / quatre fils 20 dont la fonction est de relier la chaîne émission de données et la chaîne réception de données à la ligne L.

Le convertisseur deux fils / quatre fils 20 comporte un transformateur différentiel asymétrique 13, ou transformateur hybride, et un module d'impédance de compensation variable 18 qui sera détaillé dans la suite.

Pour la partie réception de données, l'équipement 1 comporte à partir de la ligne haute tension L le convertisseur deux fils / quatre fils 20.

La sortie du convertisseur deux fils / quatre fils 20 est reliée à l'entrée d'un filtre de réception 14 qui réalise un filtrage passe-bande du signal de réception. Le signal filtré est ainsi dans la bande de fréquence de réception de l'équipement.

La sortie du filtre de réception 14 est reliée à l'entrée d'un atténuateur 15 qui corrige l'amplitude du signal qui lui est appliqué.

La sortie de l'atténuateur 15 est reliée à l'entrée d'un convertisseur analogique/numérique 16 pour recevoir le signal de réception après filtrage et atténuation. Le convertisseur 16 extrait des données à partir du signal analogique qu'il reçoit.

Un module d'adaptation d'impédance réactive 17 est relié au niveau de l'accès à la ligne haute tension L. le module d'adaptation d'impédance réactive 17 comporte un condensateur et un commutateur. Le condensateur a une capacité de valeur fixe. Le condensateur peut être relié en parallèle sur l'accès ligne dans le cas où la ligne L présente une impédance réactive de type inductif, de manière que l'impédance vue redevienne capacitive. Ce réglage est effectué lors de la mise en service de l'équipement, plus précisément au cours du réglage de la compensation d'impédance complexe réalisé dans le transformateur hybride.

Le convertisseur deux fils / quatre fils 20 est imparfait, car une partie du signal émis est réinjecté dans la chaîne de réception. Dans la mesure où le signal émis possède un niveau de puissance en général bien supérieur à celui du signal reçu, la partie de signal émis réinjectée peut avoir un niveau de puissance suffisamment important pour les signaux provenant d'un équipement distant. Le signal réinjecté constitue ainsi une perturbation dans la chaîne de réception, en particulier si les bandes de fréquence d'émission et de réception sont confondues.

Pour illustrer cela, la **figure 2** représente un exemple schématique de répartition fréquentielle des signaux dans un cas où les bandes de fréquence d'émission et de réception sont confondues.

Une fréquence porteuse émission Ctx et une fréquence porteuse réception Crx sont séparées par une bande de fréquence dans laquelle est situé le signal modulé utile émis et reçu.

Si les bandes de fréquence de réception et d'émission ne sont pas confondues, la mise en œuvre de l'invention nécessite que le filtre de réception 14 couvre la totalité des deux bandes de fréquences, soit d'un seul tenant si les bandes sont adjacentes ou voisines, soit en combinant deux filtres si elles sont éloignées.

Selon la présente invention, l'équipement 1 de transmission de données comporte le module d'impédance de compensation variable 18 relié entre le transformateur différentiel 13 et la masse.

Le module d'impédance de compensation variable 18 comporte une partie résistive et une partie réactive.

Un module de commande 19 pilote d'une part la transmission et la réception de données proprement dites. Le module de commande 19 est donc relié au convertisseur numérique/analogique 10 et au convertisseur analogique/numérique 16.

Le module de commande 19 est également relié au module d'adaptation d'impédance réactive 17 et au module d'impédance de compensation variable 18. Le module de commande 19 commande ainsi le fonctionnement du module d'impédance de compensation variable 18.

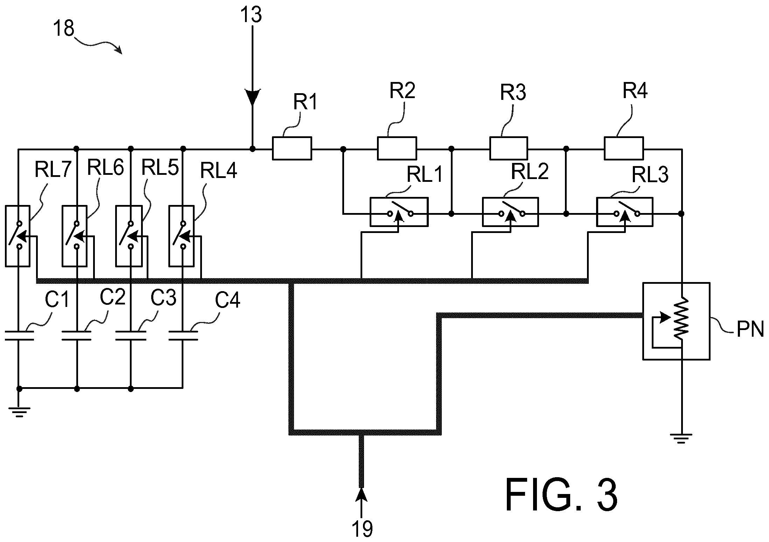

Comme représenté à la **figure 3****,** le module d'impédance de compensation variable 18 comporte une partie résistive et une partie réactive. Plus précisément, la partie résistive du module 18 comporte par exemple des résistances R1, R2 et R3 commutées par des relais électromécaniques ou statiques RL1, RL2 et RL3 et un potentiomètre numérique PN. Les relais sont utilisés pour un réglage grossier de la partie résistive puis le potentiomètre est utilisé pour un réglage fin.

En variante, la partie résistive peut comporter un opto-isolateur résistif à la place des résistances, relais et potentiomètre.

La partie réactive comporte des condensateurs C1 à C4, également commutés par des relais électromécaniques ou statiques RL4 à RL7.

Le module de commande 19 commande les relais RL1 àRL7 et le potentiomètre PN de manière à définir l'impédance de compensation.

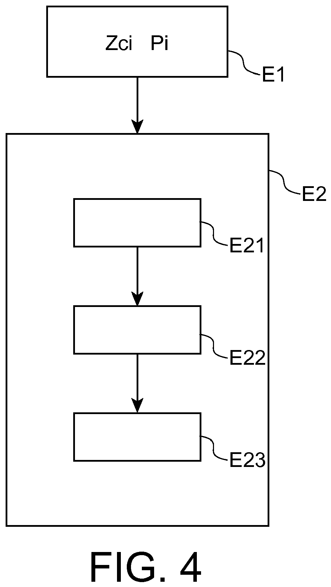

La **figure 4** représente le fonctionnement du module d'impédance de compensation variable 18 commandé par le module de commande 19, sous la forme d'un organigramme comportant des étapes E1 à E2.

L'étape E1 est une initialisation qui est réalisée après la mise sous tension de l'équipement 1 et un ajustement des gains effectué par un système de contrôle automatique des gains, classique en soi et non décrit dans la présente demande.

L'initialisation comporte l'émission d'un signal de référence prédéterminé et la recherche du minimum de puissance du signal réinjecté dans la chaîne de réception.

Le signal de référence est préférentiellement le signal de porteuse émission, qui est représenté à la figure 2. Dans le cas où la modulation est réalisée sans émission de fréquence porteuse, il est nécessaire d'émettre un signal de référence spécifique pour mesurer sa réinjection. Ce signal est constitué d'une simple sinusoïde.

La puissance de la partie réinjectée du signal de référence (porteuse émission ou fréquence de référence) est mesurée à l'aide d'un filtre numérique étroit centré sur cette fréquence et d'une mesure de puissance suivie d'une intégration pour donner une image stable de cette puissance. Il est à noter que la mesure n'a pas besoin d'être rapide.

La phase suivante consiste à rechercher le minimum de la valeur de cette puissance en fonction de l'impédance de compensation, définie par le réglage du module 18. On peut pour cela utiliser un algorithme classique de recherche d'extremum, par exemple par dichotomie successive.

L'étape E1 a pour résultat une valeur initiale de l'impédance de compensation Zci qui minimise la puissance du signal de référence réinjectée à une valeur Pi.

La valeur initiale d'impédance de compensation Zci est ensuite utilisée comme valeur de référence et reste figée durant une phase d'initialisation et de synchronisation de la communication. Cette phase est classique et connue de l'homme du métier. Elle ne sera donc pas décrite ici.

Une fois terminée cette phase d'initialisation et de synchronisation de la communication, la communication est établie et le procédé selon l'invention passe alors à l'étape E2 de régulation de la réinjection de signal d'émission dans la chaîne de réception.

L'étape E2 comporte des sous-étapes E21 à E23. L'étape E21 est une mesure de la puissance du signal de porteuse émission réinjecté dans la chaîne de réception.

S'il n'y a pas de porteuse émission, on ajoute un signal sinusoïdal en émission. De préférence, ce signal sinusoïdal ajouté est un signal stable en fréquence et en puissance localisé sur le bord du spectre utile et émis avec un niveau de puissance faible pour, d'une part, ne pas perturber le signal utile et, d'autre part, pour ne pas dépenser inutilement la puissance de l'émetteur. Ce signal peut n'être émis qu'au moment de faire la mesure.

La mesure de puissance est effectuée comme lors de l'étape E1 d'initialisation, à l'aide d'un filtre numérique étroit centré sur la fréquence de la porteuse ou du signal ajouté et d'une mesure de puissance suivie d'une intégration pour donner une image stable de cette puissance.

L'étape suivante E22 est un test pour déterminer si la puissance mesurée est dans un intervalle prédéterminé autour de la valeur Pi de la puissance réinjectée qui a été déterminée à l'étape E1.

Si la réponse est positive, l'étape E22 est suivie de l'étape E21 précédemment décrite.

Si la réponse est négative, l'étape E22 est suivie de l'étape E23 qui est une recherche du minimum de puissance du signal réinjecté dans la chaîne de réception.

Comme lors de l'étape E1, on recherche le minimum de la valeur de cette puissance en fonction de l'impédance de compensation, définie par le réglage du module 18. On peut pour cela utiliser un algorithme classique de recherche d'extremum, par exemple par dichotomie successive.

Il est à noter que le seul paramètre de réglage est ici la valeur d'impédance de compensation Zc. En effet, le caractère inductif ou capacitif de la ligne L est permanent et il n'est pas utile de faire varier le réglage du module d'adaptation d'impédance réactive 17.

L'étape E23 est suivie de l'étape E21 précédemment décrite.

L'étape E2 est mise en œuvre régulièrement pendant que la communication est établie, par exemple toutes les minutes. Le réglage de la réinjection de signal d'émission dans la chaîne de réception est ainsi optimisé à tout moment.

## Revendications

1. Dispositif de réglage de la réinjection d'un signal d'émission dans une chaîne de réception d'un équipement de transmission de données par courants porteurs en ligne, l'équipement de transmission de données comportant un convertisseur deux fils / quatre fils (20) pour relier une chaîne d'émission de données et la chaîne réception de données à une ligne (L), le convertisseur comportant un transformateur différentiel asymétrique (13), **caractérisé en ce qu'**il comporte :
- un moyen de mesure (18, 19) de la puissance d'un signal réinjecté dans la chaîne de réception, lorsque le signal d'émission est émis,
- un moyen de comparaison (18, 19) de la puissance mesurée avec une valeur prédéterminée de puissance,
- un module d'impédance de compensation variable, comportant une impédance de compensation et relié entre le transformateur différentiel asymétrique et la masse,
- un moyen de réglage (18, 19) de la valeur de l'impédance de compensation (Zc), si la puissance mesurée est en dehors d'un intervalle prédéterminé autour de la valeur prédéterminée de puissance.

2. Dispositif de réglage selon la revendication 1, **caractérisé en ce qu'**il est adapté à régler la valeur prédéterminée de puissance et **en ce qu'**il comporte :
- un moyen d'émission d'un signal de référence,
- un moyen de mesure de la puissance d'un signal réinjecté dans la chaîne de réception lorsque le signal de référence est émis, et
- un moyen de réglage de la valeur de l'impédance de compensation, adapté à minimiser la puissance du signal réinjecté, la valeur prédéterminée de puissance étant réglée à la valeur minimale de la puissance du signal réinjecté.

3. Dispositif de réglage selon la revendication 2, **caractérisé en ce que** le signal de référence est un signal de porteuse émission utilisé dans une modulation du signal d'émission.

4. Dispositif de réglage selon la revendication 2, **caractérisé en ce que** le signal de référence est un signal sinusoïdal prédéterminé.

5. Dispositif de réglage selon l'une quelconque des revendications 1 à 4, **caractérisé en ce que** le module d'impédance de compensation variable comporte une partie résistive et une partie réactive, et **en ce que** le moyen de réglage (18) de la valeur de l'impédance de compensation comporte un module de commande pour régler les valeurs de réglage de la partie résistive et de la partie réactive.

6. Equipement de transmission de données par courants porteurs en ligne (1), **caractérisé en ce qu'**il comporte un dispositif de réglage selon l'une quelconque des revendications 1 à 5.

7. Procédé de réglage de la réinjection d'un signal d'émission dans une chaîne de réception d'un équipement de transmission de données par courants porteurs en ligne, l'équipement de transmission de données comportant un convertisseur deux fils / quatre fils (20) pour relier une chaîne d'émission de données et la chaîne réception de données à une ligne (L), le convertisseur comportant un transformateur différentiel asymétrique (13), **caractérisé en ce qu'**il comporte des étapes de :
- mesure (E21) de la puissance d'un signal réinjecté dans la chaîne de réception, lorsque le signal d'émission est émis,
- comparaison (E22) de la puissance mesurée avec une valeur prédéterminée de puissance, et
- réglage (E23) de la valeur d'une impédance de compensation comprise dans un module d'impédance de compensation variable relié entre le transformateur différentiel asymétrique et la masse, si la puissance mesurée est en dehors d'un intervalle prédéterminé autour de la valeur prédéterminée de puissance.

8. Procédé de réglage selon la revendication 7, **caractérisé en ce qu'**il est adapté à régler la valeur prédéterminée de puissance et **en ce qu'**il comporte des étapes (E1) de :
- émission d'un signal de référence,
- mesure de la puissance d'un signal réinjecté dans la chaîne de réception lorsque le signal de référence est émis, et
- réglage de la valeur de l'impédance de compensation, de manière à minimiser la puissance du signal réinjecté, la valeur prédéterminée de puissance étant réglée à la valeur minimale de la puissance du signal réinjecté.

9. Programme d'ordinateur comportant des instructions pour l'exécution des étapes du procédé selon la revendication 7 ou 8 lorsque ledit programme est exécuté par un ordinateur.

10. Support d'enregistrement lisible par un ordinateur sur lequel est enregistré un programme d'ordinateur comprenant des instructions pour l'exécution des étapes du procédé selon la revendication 7 ou 8.

## Patentansprüche

1. Vorrichtung zum Regeln der Rückkopplung eines Sendesignals in eine Empfangskette einer Powerline-Datenübertragungsausrüstung, wobei die Datenübertragungsausrüstung einen Zweidraht-/Vierdraht-Wandler (20) umfasst, um eine Datensendekette und die Datenempfangskette mit einer Leitung (L) zu verschalten, wobei der Wandler einen asymmetrischen Differentialtransformator (13) umfasst, **dadurch gekennzeichnet, dass** er umfasst:
- ein Mittel (18, 19) zum Messen der Leistung eines Signals, das in die Empfangskette rückgekoppelt wird, wenn das Sendesignal gesendet wird,
- ein Mittel (18, 19) zum Vergleichen der gemessenen Leistung mit einem vorbestimmten Leistungswert,
- ein Modul mit variabler Kompensationsimpedanz, das eine Kompensationsimpedanz umfasst und zwischen den asymmetrischen Differentialtransformator und die Masse geschaltet ist,
- ein Mittel (18, 19) zum Regeln des Werts der Kompensationsimpedanz (Zc), wenn die gemessene Leistung außerhalb eines vorbestimmten Intervalls um den vorbestimmten Leistungswert liegt.

2. Regelvorrichtung nach Anspruch 1, **dadurch gekennzeichnet, dass** sie dazu geeignet ist, den vorbestimmten Leistungswert zu regeln, und dadurch, dass sie umfasst:
- ein Mittel zum Senden eines Referenzsignals,
- ein Mittel zum Messen der Leistung eines Signals, das in die Empfangskette rückgekoppelt wird, wenn das Referenzsignal gesendet wird, und
- ein Mittel zum Regeln des Werts der Kompensationsimpedanz, das dazu geeignet ist, die Leistung des rückgekoppelten Signals zu minimieren, wobei der vorbestimmte Leistungswert auf den Minimalwert der Leistung des rückgekoppelten Signals geregelt wird.

3. Regelvorrichtung nach Anspruch 2, **dadurch gekennzeichnet, dass** es sich beim Referenzsignal um ein Sendeträgersignal handelt, das bei einer Modulation des Sendesignals verwendet wird.

4. Regelvorrichtung nach Anspruch 2, **dadurch gekennzeichnet, dass** es sich beim Referenzsignal um ein vorbestimmtes Sinussignal handelt.

5. Regelvorrichtung nach einem der Ansprüche 1 bis 4, **dadurch gekennzeichnet, dass** das Modul mit variabler Kompensationsimpedanz einen ohmschen Anteil und einen reaktiven Anteil umfasst, und dadurch, dass das Mittel (18) zum Regeln des Werts der Kompensationsimpedanz ein Steuermodul umfasst, um die Regelungswerte des ohmschen Anteils und des reaktiven Anteils zu regeln.

6. Powerline-Datenübertragungsausrüstung (1), **dadurch gekennzeichnet, dass** sie eine Regelvorrichtung nach einem der Ansprüche 1 bis 5 umfasst.

7. Verfahren zum Regeln der Rückkopplung eines Sendesignals in eine Empfangskette einer Powerline-Datenübertragungsausrüstung, wobei die Datenübertragungsausrüstung einen Zweidraht-/Vierdraht-Wandler (20) umfasst, um eine Datensendekette und die Datenempfangskette mit einer Leitung (L) zu verschalten, wobei der Wandler einen asymmetrischen Differentialtransformator (13) umfasst, **dadurch gekennzeichnet, dass** es Schritte umfasst des:
- Messens (E21) der Leistung eines Signals, das in die Empfangskette rückgekoppelt wird, wenn das Sendesignal gesendet wird,
- Vergleichens (E22) der gemessenen Leistung mit einem vorbestimmten Leistungswert, und
- Regelns (E23) des Werts einer Kompensationsimpedanz, die in einem Modul mit variabler Kompensationsimpedanz umfasst ist, das zwischen den asymmetrischen Differentialtransformator und die Masse geschaltet ist, wenn die gemessene Leistung außerhalb eines vorbestimmten Intervalls um den vorbestimmten Leistungswert liegt.

8. Regelverfahren nach Anspruch 7, **dadurch gekennzeichnet, dass** es dazu geeignet ist, den vorbestimmten Leistungswert zu regeln, und dadurch, dass es Schritte (E1) umfasst des:
- Sendens eines Referenzsignals,
- Messens der Leistung eines Signals, das in die Empfangskette rückgekoppelt wird, wenn das Referenzsignal gesendet wird, und
- Regelns des Werts der Kompensationsimpedanz, um die Leistung des rückgekoppelten Signals zu minimieren, wobei der vorbestimmte Leistungswert auf den Minimalwert der Leistung des rückgekoppelten Signals geregelt wird.

9. Computerprogramm, das Anweisungen umfasst zum Ausführen der Schritte des Verfahrens nach Anspruch 7 oder 8, wenn das Programm von einem Computer ausgeführt wird.

10. Aufzeichnungsträger, der von einem Computer gelesen werden kann, auf dem ein Computerprogramm aufgezeichnet ist, das Anweisungen zum Ausführen der Schritte des Verfahrens nach Anspruch 7 oder 8 umfasst.

## Claims

1. Device for adjusting the feedback of a transmission signal in a reception chain of power-line data transmission equipment, the data transmission equipment comprising a two wire/four wire transformer (20) for connecting a data transmission chain and the data reception chain to a line (L), the transformer comprising an asymmetrical differential transformer (13), **characterised in that** it comprises:
- a means for measuring (18, 19) the power of a signal fed back into the reception chain, when the transmission signal is emitted,
- a means for comparing (18, 19) the measured power with a predetermined power value,
- a variable compensation impedance module, comprising a compensation impedance and connected between the differential transformer and the ground,
- a means for adjusting (18, 19) the compensation impedance value (Zc), if the measured power is outside a predetermined range around the predetermined power value.

2. Adjusting device according to claim 1, **characterised in that** it is adapted to adjust the predetermined power value and that it comprises:
- a means for transmitting a reference signal,
- a means for measuring the power of a signal fed back into the reception chain when the reference signal is emitted, and
- a means for adjusting the value of the compensation impedance, adapted to minimise the power of the feedback signal, the predetermined power value being set to the minimum value of the power of the feedback signal.

3. Adjusting device according to claim 2, **characterised in that** the reference signal is a transmission carrier signal used in a modulation of the transmission signal.

4. Adjusting device according to claim 2, **characterised in that** the reference signal is a predetermined sinusoidal signal.

5. Adjusting device according to any one of claims 1 to 4, **characterised in that** the variable compensation impedance module has a resistive portion and a reactive portion, and **in that** the means of adjusting (18) the compensation impedance value comprises a control module for adjusting the control values of the resistive portion and the reactive portion.

6. Power-line data transmission equipment (1), **characterised in that** it comprises an adjusting device according to any one of claims 1 to 5.

7. Method for adjusting the feedback of a transmission signal in a reception chain of power-line data transmission equipment, the data transmission equipment comprising a two wire/four-wire transformer (20) for connecting a data transmission chain and the data reception chain to a line (L), the transformer comprising an asymmetrical differential transformer (13), **characterised in that** it comprises steps of:
- measuring (E21) the power of a signal fed back into the reception chain, when the transmission signal is emitted,
- comparison (E22) of the measured power with a predetermined power value, and,
- adjustment (E23) of the compensation impedance value included in a variable compensation impedance module connected between the differential transformer and the ground, if the measured power is outside a predetermined range around the predetermined power value.

8. Adjustment method according to claim 7, **characterised in that** it is adapted to adjust the predetermined power value and that it comprises steps (E1) of:
- sending a reference signal,
- measuring the power of a signal fed back into the reception channel when the reference signal is emitted, and
- adjusting the compensation impedance value, so as to minimise the power of the feedback signal, the predetermined power value being set to the minimum value of the power of the feedback signal.

9. Computer programme comprising instructions for executing the steps of the method according to claim 7 or 8 when said programme is executed by a computer.

10. Computer readable recording medium on which a computer programme is recorded including instructions for performing the steps of the method according to claim 7 or 8.
